# EUROPEAN PATENT SPECIFICATION

(11) **EP 3 865 737 B1**
(45) Date of publication and mention of the grant of the patent: **10.08.2022**
(21) Application number: 21156564.3
(22) Date of filing: 11.02.2021
(51) Int. Cl.: F16H 61/26, H03K 17/97, F16H 63/50

(54) **SHIFT DEVICE**
SCHALTVORRICHTUNG
DISPOSITIF DE CHANGEMENT DE VITESSE

(30) Priority: 13.02.2020 JP 2020022312
(43) Date of publication of application: 18.08.2021
(73) Proprietor: Asahi Denso Co., Ltd., Shizuoka 434-0046 (JP)
(72) Inventor: SUZUKI, Michiyuki, Hamamatsu City, Shizuoka 434-0043 (JP)
(74) Representative: Grünecker Patent- und Rechtsanwälte PartG mbB

(56) References cited:
- EP-A1- 3 264 028
- EP-A1- 3 264 045
- DE-A1-102010 015 036
- US-B1- 6 374 691

## Description

### Technical Field

The present invention relates to a shift device for transmitting a shift operation of a shift pedal of a vehicle to a transmission to perform a gear-shifting operation.

### Background Art

A stroke sensor known from EP 3 264 028 A1, comprises a shaft that extends in a direction along an axial line, a detected body that is fixed to the shaft, a housing that extends along the shaft, that houses the shaft, and that supports the shaft slidably in the direction along the axial line, and a detection body that detects a movement amount of the detected body which moves in accordance with sliding of the shaft. The shaft comprises a plurality of shaft members that are connected to each other in the direction along the axial line and that are formed of metal. A slide part that slides so as to regulate a movement of the shaft in a direction that is crossed with the axial line is provided on each of the plurality of shaft members.

US 6 374 691 B1 discloses an apparatus for shifting a transmission coupled to an engine including a controller for shifting the transmission between operating modes. Said apparatus includes a longitudinal tube connected to the controller, a cylindrical slide connected to an actuator for actuating a control lever in response to shifting of the controller, the longitudinal tube being coaxial with the cylindrical slide, a detector for detecting relative displacement between the longitudinal tube and the cylindrical slide, and a spring acting between the longitudinal tube and the cylindrical slide to prevent relative displacement between them until a force acting on one of them exceeds the spring force of the spring.

A transmission of a motorcycle or the like is capable of performing gear-shifting according to a shift operation of a shift pedal by a driver. In a recent year, it is proposed that a shift device is attached in a middle of a transmission path for transmitting an operating force of a shift pedal to a transmission. As a shift device of the related art, for example, as disclosed in DE 10 2010 015 036 A1, a device having a shaft member which can be displaced according to a shift operation of a shift pedal, a housing which accommodates the shaft member in a displaceable manner, a magnet attached to the shaft member, and a magnetic sensor attached to the housing can be exemplified.

Such a shift device of the related art is configured such that, when the operation of the shift pedal is started and the magnetic sensor detects that the shaft member is displaced relative to the housing, an engine of a vehicle is controlled to adjust drive torque, and when the shaft member and housing move integrally in a state where the shaft member reaches a displacement end, a gear-shifting operation of the transmission is performed. As a result, the gear-shifting operation can be performed without operating a clutch.

However, in the above-described related art, since the start of operation of the shift pedal is detected by detecting a movement of the magnet with the magnetic sensor, there is a risk of malfunction due to an influence of external magnetism. It is also conceivable to attach a shielding member which shields external magnetism around the magnetic sensor in order to suppress the influence of the external magnetism. However, in that case, there is a problem that the number of parts increases by at least the shielding member, which leads to a decrease in assembling property and an increase in manufacturing cost.

### Summary

The invention is made in view of such circumstances and an object of the invention is to provide a shift device which can prevent malfunction due to external magnetism by eliminating the need for a magnet and can accurately detect the start of operation of a shift pedal.

According to the present invention, there is provided a shift device for transmitting a shift operation of a shift pedal of a vehicle to a transmission to perform a gear-shifting operation, comprising: a shaft member which is configured to be displaced according to the shift operation of the shift pedal of the vehicle; a housing which is configured to accommodate the shaft member in a displaceable manner and move integrally with the shaft member in a state where the shaft member reaches a displacement end to perform the gear-shifting operation of the vehicle; a detecting unit which is configured to detect displacement of the shaft member with respect to the housing; and an accommodation case, where the detecting unit includes: an electromagnetic field detection unit, in which a transmission circuit which is configured to generate an electromagnetic field by supplying a high-frequency signal, and a reception circuit which is formed in the transmission circuit and which is configured to receive the electromagnetic field generated by the transmission circuit to generate a voltage, are formed on a substrate, and which is formed along a displacement direction of the shaft member; a shielding portion which is close to the electromagnetic field detection unit at a position corresponding to the displacement of the shaft member and which is configured to shield the electromagnetic field generated by the transmission circuit of the electromagnetic field detection unit; and a displacement detection unit which is configured to detect the displacement of the shaft member based on a voltage change in the reception circuit caused by shielding of the electromagnetic field by the shielding portion, wherein the accommodation case accommodates the electromagnetic field detection unit, and the shielding portion is configured to slide on a slide receiving surface formed on the accommodation case corresponding to the displacement of the shaft member.

Therefore, it is possible to prevent malfunction due to external magnetism by eliminating the need for a magnet and it is possible to accurately detect the start of the operation of the shift pedal. Therefore, the shielding portion can be smoothly guided with the displacement of the shaft member and the electromagnetic field generated by the transmission circuit of the electromagnetic field detection unit can be shielded accurately.

The shaft member may be made of a metal member capable of shielding the electromagnetic field generated by the transmission circuit and the shielding portion is made of a part of the shaft member.

Therefore, the shaft member and the shielding portion can be integrally formed, and thus the number of parts can be reduced by eliminating the need for separate parts.

The shielding portion may include a protruding end surface formed so as to protrude from the shaft member toward the electromagnetic field detection unit.

Therefore, the electromagnetic field generated by the transmission circuit of the electromagnetic field detection unit can be reliably shielded.

In the shaft member, a sliding surface may be formed on a side opposite to a side, where the shielding portion is formed, and a slide receiving surface configured to slide the sliding surface may be formed on the housing.

Therefore, the shaft member and the shielding portion can be smoothly guided with the displacement of the shaft member.

The electromagnetic field detection unit and the displacement detection unit may be formed on a same substrate.

Therefore, the number of parts can be reduced as compared with those in which the electromagnetic field detection unit and the displacement detection unit are formed separately.

### Brief Description of the Drawings

Fig. 1 is a plan view and a side view illustrating a shift device according to an embodiment of the invention.
Fig. 2 is a perspective view illustrating the shift device.
Fig. 3 is a cross-sectional view taken along the line III-III in Fig. 1.
Fig. 4 is a cross-sectional view taken along the line IV-IV in Fig. 1.
Fig. 5 is a cross-sectional view taken along the line V-V in Fig. 1.
Fig. 6 is a four-orthogonal view illustrating a shaft member of the shift device.
Fig. 7 is a perspective view illustrating the shaft member of the shift device.
Fig. 8 is a front view and a side view illustrating a state in which a coil spring is attached to the shaft member of the shift device.
Fig. 9 is a perspective view illustrating the state in which the coil spring is attached to the shaft member of the shift device.
Fig. 10 is a three-orthogonal view illustrating a housing of the shift device.
Fig. 11 is a perspective view illustrating the housing of the shift device.
Fig. 12 is a three-orthogonal view illustrating an accommodation case of the shift device.
Fig. 13 is a perspective view illustrating the accommodation case of the shift device.
Fig. 14 is a plan view and a rear view illustrating a substrate on which an electromagnetic field detection unit and a displacement detection unit of the shift device are formed.
Fig. 15 is a side view illustrating a positional relationship between an electromagnetic field detection unit formed on the substrate of the shift device and a shielding portion formed on the shaft member.
Fig. 16 is a schematic view for illustrating an operating principle of the electromagnetic field detection unit in the shift device.

### Description of Embodiments

Hereinafter, an embodiment of the invention will be specifically described with reference to the drawings.

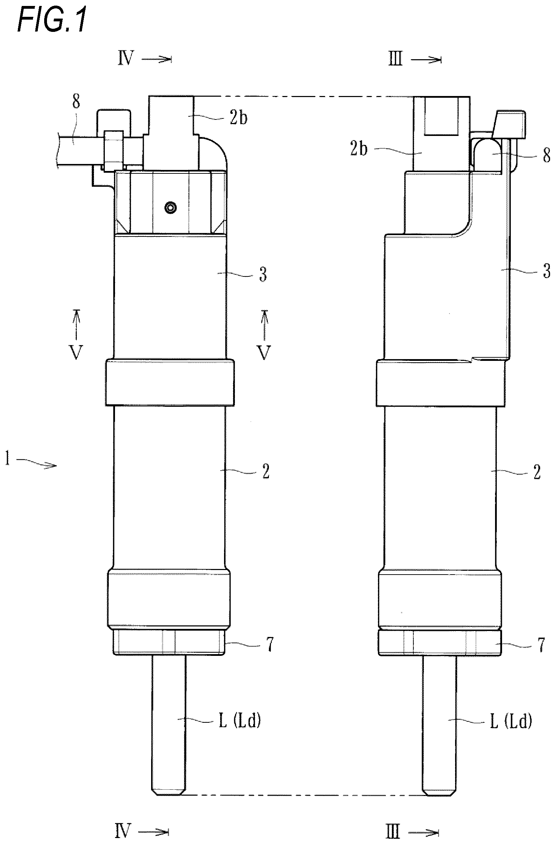

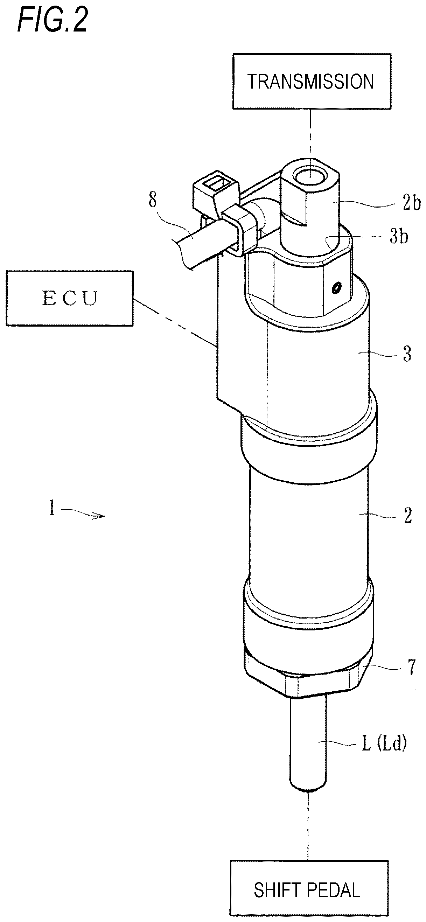

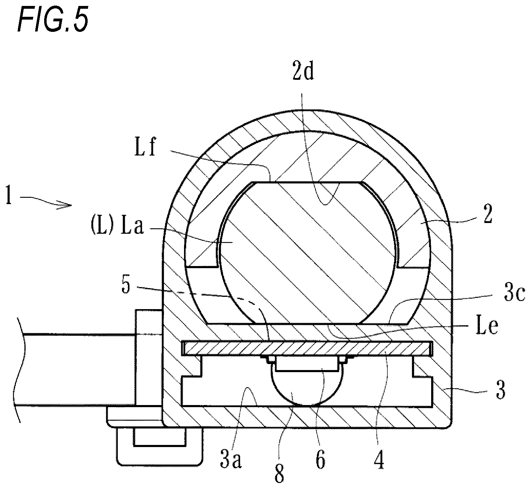

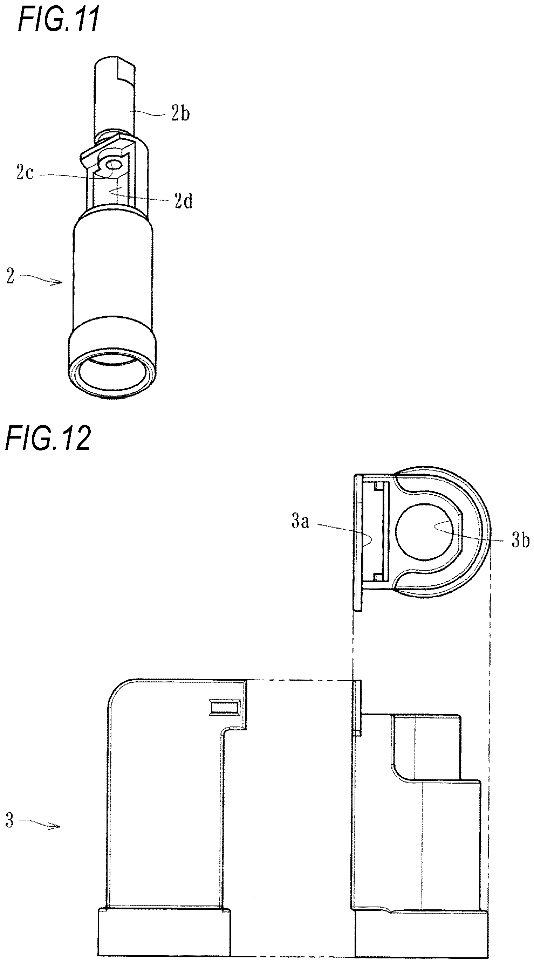

A shift device 1 according to the embodiment is for transmitting a shift operation of a shift pedal of a vehicle (particularly a two-wheeled vehicle) to a transmission to perform a gear-shifting operation. As illustrated in Figs. 1 to 15, the shift device 1 is composed of including a shaft member L, a housing 2, an accommodation case 3, an electromagnetic field detection unit 5 and a displacement detection unit 6 formed on a substrate 4, and the shaft member L on which a shielding portion Le is formed.

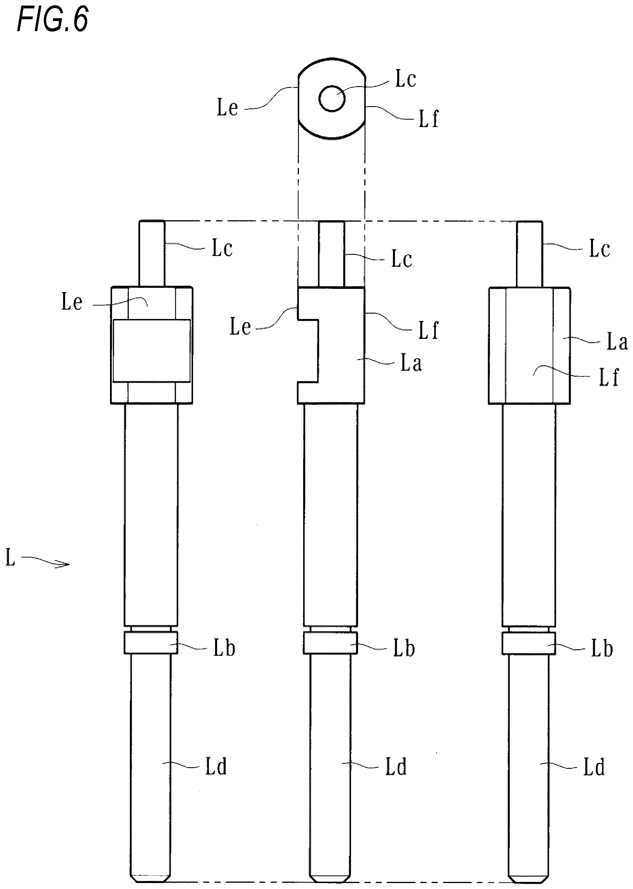

The shaft member L is connected to the shift pedal of the vehicle and can be displaced according to the shift operation of the shift pedal. As illustrated in Figs. 6 to 9, the shaft member L is composed of a shaft-shaped member on which a first diameter-expanded portion La and a second diameter-expanded portion Lb are formed. The first diameter-expanded portion La and the second diameter-expanded portion Lb are composed of portions which protrude further in a lateral side than other portions. A coil spring S is attached between the first diameter-expanded portion La and the second diameter-expanded portion Lb.

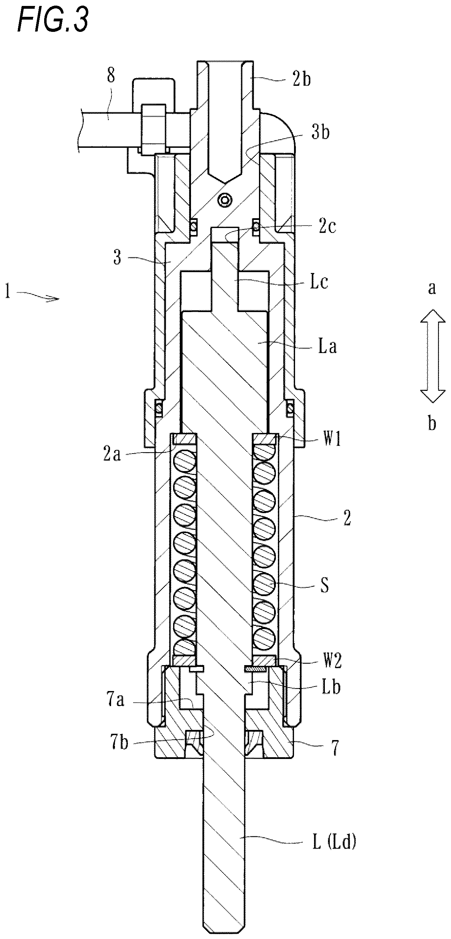

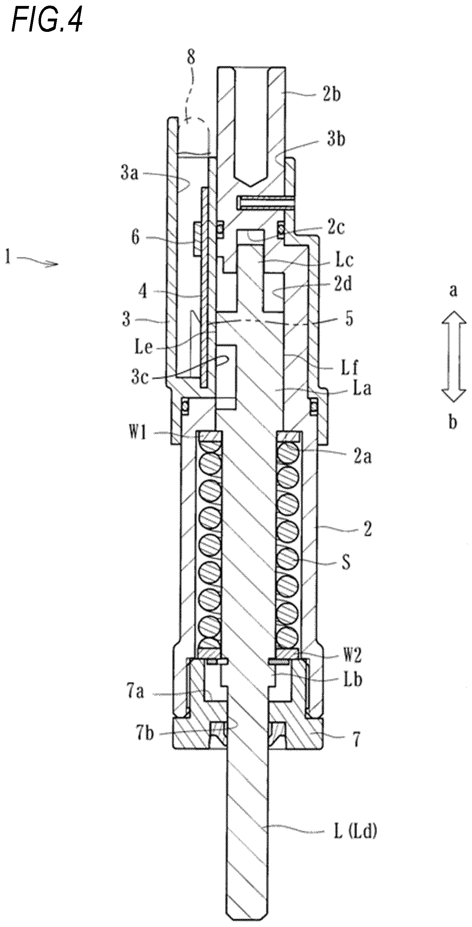

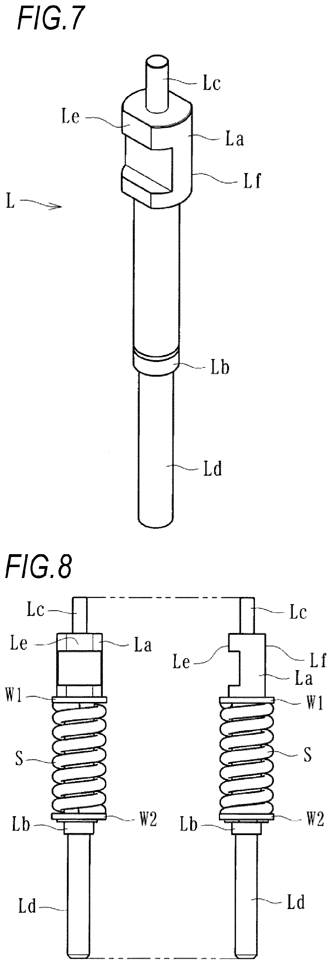

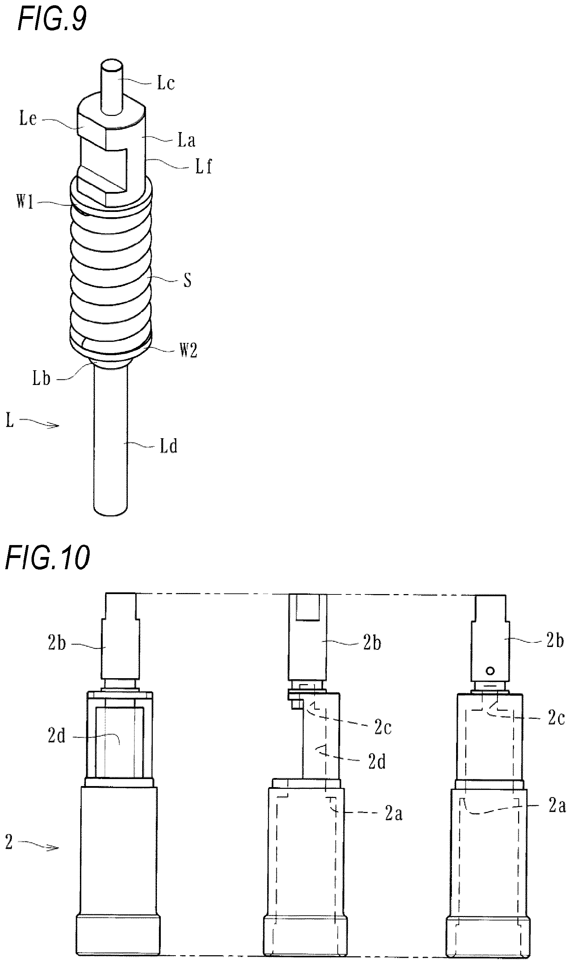

Specifically, a receiving member W1 having a washer shape is attached to an end surface (lower surface in Figs. 8 and 9) of the first diameter-expanded portion La and a receiving member W2 having a washer shape is attached to an end surface (upper surface in Figs. 8 and 9) of the second diameter-expanded portion Lb. The coil spring S is assembled between those receiving members W1 and W2. Further, as illustrated in Figs. 3 and 4, the shaft member L is inserted into an insertion hole 2c formed in the housing 2 at a tip end portion Lc and a base end portion Ld is assembled so as to extend from a lower end portion of the housing 2. The base end portion Ld of the shaft member L is configured so that the shift pedal of the vehicle can be connected thereto and can be displaced in an up-down direction according to the operation of the shift pedal.

The housing 2 accommodates the shaft member L in a displaceable manner and can move integrally with the shaft member L in a state where the shaft member L reaches a displacement end to perform the gear-shifting operation of the vehicle. As illustrated in Figs. 3, 4, 10, and 11, the housing 2 is configured to have a regulation surface 2a, a connecting portion 2b, an insertion hole 2c, and a slide receiving surface 2d. The regulation surface 2a is composed of a surface which interferes with the receiving member W1 attached to the first diameter-expanded portion La in a process of displacement of the shaft member L in an a direction (see Figs. 3 and 4). The regulation surface 2a is configured such that, as the shaft member L reaches the displacement end in the a direction due to such interference and the shaft member L is further displaced in the a direction, the shaft member L and the housing 2 can move integrally in the same direction.

The connecting portion 2b is composed of a portion protruding from an upper part of the housing 2 and is configured to be connected to an input mechanism or the like of the transmission of the vehicle. Further, the insertion hole 2c is composed of a hole through which the tip end portion Lc of the shaft member L can be inserted and allows the shaft member L to be displaced in an axial direction (a and b directions). Further, the slide receiving surface 2d is formed of a flat surface on which a sliding surface Lf formed on the shaft member L can be slid in a displacement process of the shaft member L.

A sealing member 7 is attached to a lower end portion of the housing 2 and a regulation surface 7a and an insertion hole 7b are formed on the sealing member 7. The regulation surface 7a is composed of a surface which interferes with the receiving member W2 attached to the second diameter-expanded portion Lb in a process of displacement of the shaft member L in the b direction (see Figs. 3 and 4). The regulation surface 7a is configured such that, as the shaft member L reaches the displacement end in the b direction due to such interference and the shaft member L is further displaced in the b direction, the shaft member L and the housing 2 can move integrally in the same direction. Further, the insertion hole 7b is composed of a hole through which the base end portion Ld of the shaft member L can be inserted and allows the shaft member L to be displaced in the axial direction (a and b directions).

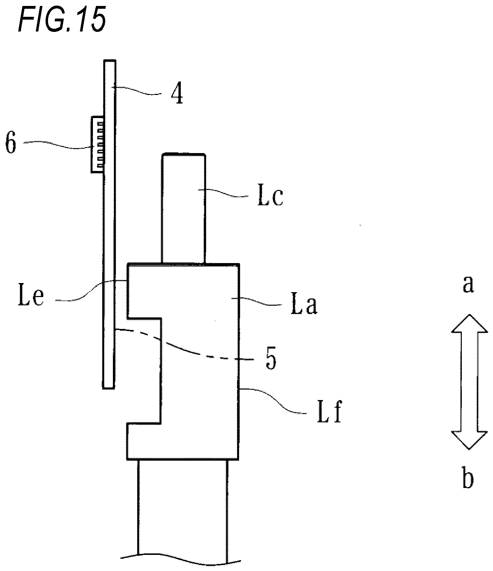

The accommodation case 3 accommodates the electromagnetic field detection unit 5 formed on the substrate 4. As illustrated in Figs. 1 to 5, 12, and 13, the accommodation case 3 is configured of including a mounting hole 3a capable of filling a sealing material while accommodating the substrate 4, 0 The shielding portion Le of the shaft member L and the electromagnetic field detection unit 5 of the substrate 4 are arranged to face each other via a wall surface on which the slide receiving surface 3c is formed. As illustrated in Fig. 15, when the shaft member L is displaced in the axial direction (a and b directions), the shielding portion Le can move relative to the electromagnetic field detection unit 5.

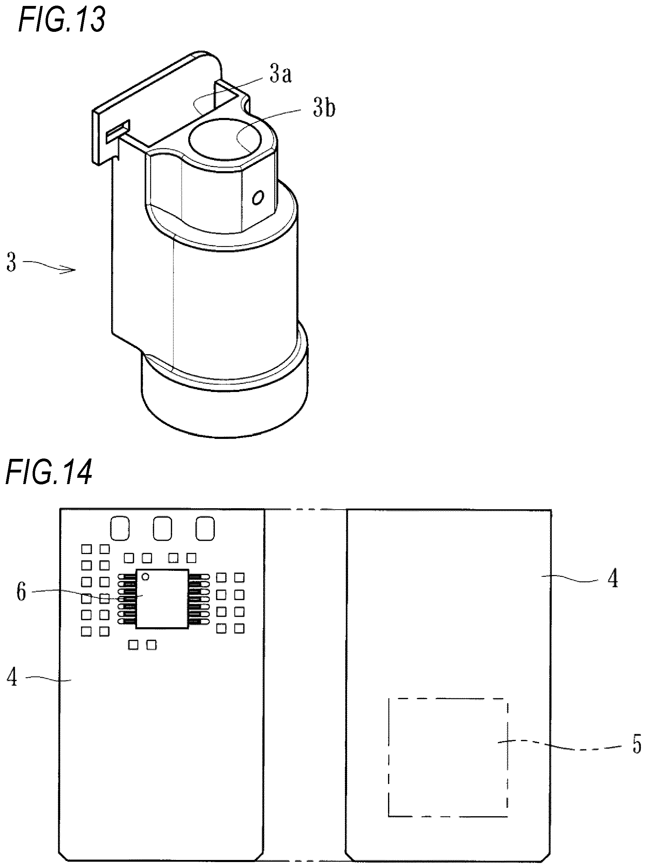

Here, the shift device 1 according to the embodiment includes a detecting unit for detecting the displacement of the shaft member L with respect to the housing 2. The detecting unit according to the embodiment includes the electromagnetic field detection unit 5 and the displacement detection unit 6 formed on the substrate 4, and the shielding portion Le formed on the shaft member L. As illustrated in Fig. 14, the substrate 4 according to the embodiment is composed of a printed substrate having the electromagnetic field detection unit 5 formed on one surface (front surface) and the displacement detection unit 6 formed on the other surface (back surface).

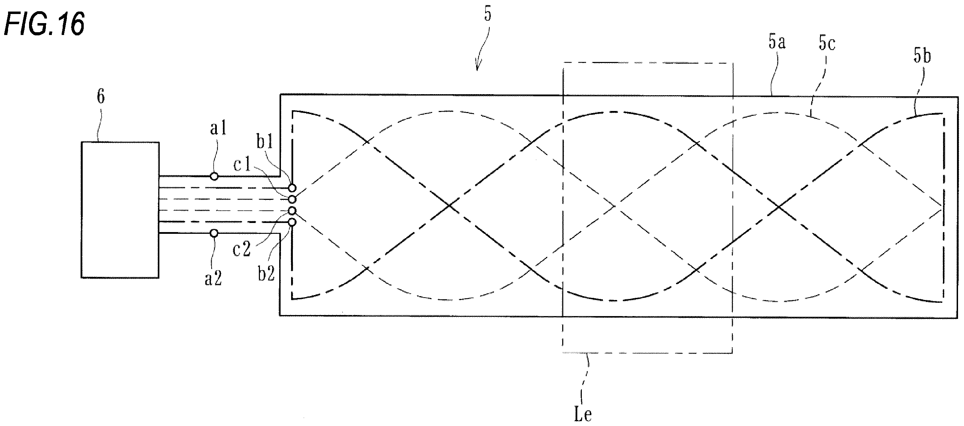

In the electromagnetic field detection unit 5, as illustrated in Fig. 16, a transmission coil 5a (transmission circuit) which generates an electromagnetic field by supplying a high-frequency signal and a reception circuit (5b, 5c) which is formed in the transmission coil 5a and can receive the electromagnetic field generated by the transmission coil 5a to generate a voltage are formed on the substrate 4. The electromagnetic field detection unit 5 is formed linearly along the displacement direction of the shaft member L. More specifically, in the electromagnetic field detection unit 5 according to the embodiment, a first reception circuit 5b (Cos shape) and a second reception circuit 5c (Sin shape) whose phases are 90 degrees out of phase with each other are formed in the transmission coil 5a extending linearly, and the electromagnetic field detection unit 5 is configured such that, by receiving the electromagnetic field generated by the transmission coil 5a with the first reception circuit 5b and the second reception circuit 5c, voltages (secondary voltage) are generated respectively.

The shielding portion Le is close to the electromagnetic field detection unit 5 at a position corresponding to the displacement of the shaft member L and shields the electromagnetic field generated by the transmission coil 5a (transmission circuit) of the electromagnetic field detection unit 5. In the embodiment, it is composed of a protruding end surface of a protruding portion integrally formed with the shaft member L. That is, the shaft member L according to the embodiment is made of a metal member (specifically, a shaft-shaped member made of SUS) capable of shielding the electromagnetic field generated by the transmission coil 5a (transmission circuit), and the shielding portion Le is a part of the shaft member L and is composed of a protruding end surface (flat surface which can slide on slide receiving surface 3c) formed so as to protrude from the shaft member L toward the electromagnetic field detection unit 5 (the back surface of the substrate 4).

However, for example, by cutting a rod-shaped SUS material, the shaft member L is formed with the shielding portion Le and the sliding surface Lf in addition to the first diameter-expanded portion La, the second diameter-expanded portion Lb, the tip end portion Lc, and a substrate portion Ld, and the shielding portion Le forming the detecting unit has a configuration integrally formed with the shaft member L. Then, the shielding portion Le can slide on the slide receiving surface 3c formed in the accommodation case 3 with the displacement of the shaft member L. Further, in the shaft member L, the sliding surface Lf is formed on a side opposite to a side where the shielding portion Le is formed and the slide receiving surface 2d on which the sliding surface Lf can slide is formed on the housing 2.

The displacement detection unit 6 can detect the displacement of the shaft member L based on the voltage change in the reception circuit (first reception circuit 5b and second reception circuit 5c) generated by shielding the electromagnetic field by the shielding portion Le. As illustrated in Fig. 14, the displacement detection unit 6 of the present embodiment is composed of a microcomputer or the like attached to the substrate 4. As illustrated in Fig. 16, the displacement detection unit 6 is electrically connected to the transmission coil 4a via terminals (a1, a2), to the first reception circuit 5b via terminals (b1, b2), and to the second reception circuit 5c via terminals (c1, c2).

Then, when the shielding portion Le approaches a predetermined position of the electromagnetic field detection unit 5 and the electromagnetic field detection unit 5 is covered by the shielding portion Le, in the covered area, the voltages (secondary voltage) generated in the first reception circuit 5b and the second reception circuit 5c decrease and the electrical phases of the first reception circuit 5b and the second reception circuit 5c are 90 degrees out of phase with each other (Cos shape and Sin shape). Therefore, by detecting the voltage change in the displacement detection unit 6, the relative position (that is, the relative position of the shaft member L with respect to the housing 2) of the shielding portion Le with respect to the electromagnetic field detection unit 5 can be detected.

Then, when the relative movement of the shielding portion Le is detected by the electromagnetic field detection unit 5 and the displacement detection unit 6, it is determined whether the shaft member L (that is, the shift pedal) has started to be displaced and in which direction (a direction or b direction) the shaft member L has been operated. Therefore, the discrimination signal can be transmitted to, for example, an ECU of the vehicle. As a result, when a driver starts operating the shift pedal and the detecting unit detects that the shaft member L is displaced with respect to the housing 2, drive torque can be adjusted by controlling an engine of the vehicle and the gear-shifting operation of the transmission can be performed when the shaft member L and the housing 2 move integrally in a state where the shaft member L reaches the displacement end.

According to the embodiment, the detecting unit is equipped with the electromagnetic field detection unit 5 in which the transmission coil 5a (transmission circuit) which generates an electromagnetic field by supplying a high-frequency signal and the reception circuit (first reception circuit 5b and second reception circuit 5c) which is formed in the transmission coil 5a and can receive the electromagnetic field generated in the transmission coil 5a to generate a voltage are formed on the substrate 4 and which is formed along the displacement direction of the shaft member L, the shielding portion Le which is close to the electromagnetic field detection unit 5 at the position corresponding to the displacement of the shaft member L and shields the electromagnetic field generated by the transmission coil 5a of the electromagnetic field detection unit 5, and the displacement detection unit 6 which can detect the displacement of shaft member L based on the voltage change in the reception circuit (first reception circuit 5b and second reception circuit 5c) generated by shielding the electromagnetic field by the shielding portion Le. Therefore, it is possible to prevent malfunction due to external magnetism by eliminating the need for a magnet and it is possible to accurately detect the start of the operation of the shift pedal.

Further, the shaft member L is made of a metal member (SUS material in the embodiment) capable of shielding the electromagnetic field generated by the transmission coil 5a (transmission circuit) and the shielding portion Le consists of a part of the shaft member L. Therefore, the shaft member L and the shielding portion Le can be integrally formed, and thus the number of parts can be reduced by eliminating the need for separate parts. In particular, since the shielding portion Le according to the embodiment is composed of a protruding end surface formed so as to protrude from the shaft member L toward the electromagnetic field detection unit 5, the electromagnetic field generated by the transmission coil 5a of the electromagnetic field detection unit 5 can be reliably shielded.

Further, according to the embodiment, the accommodation case 3 accommodating the electromagnetic field detection unit 5 (that is, the substrate 4 on which the electromagnetic field detection unit 5 is formed) is provided and the shielding portion Le can slide on the slide receiving surface 3c formed in the accommodation case 3. Thus, the shielding portion Le can be smoothly guided with the displacement of the shaft member L and the electromagnetic field generated by the transmission coil 5a of the electromagnetic field detection unit 5 can be shielded accurately.

Furthermore, in the shaft member L according to the embodiment, the sliding surface Lf is formed on the side opposite to the side on which the shielding portion Le is formed and the slide receiving surface 2d capable of sliding the sliding surface Lf is formed on the housing 2. Therefore, the shaft member L and the shielding portion Le can be smoothly guided with the displacement of the shaft member L. Further, since the electromagnetic field detection unit 5 and the displacement detection unit 6 according to the embodiment are formed on the same substrate 4, compared with those in which the electromagnetic field detection unit 5 and the displacement detection unit 6 are formed separately, the number of parts can be reduced.

Although the embodiment is described above, the invention is not limited to this. For example, the shielding portion Le forming the detecting unit may be made of a member separate from the shaft member L, or may be made of another material. Further, in the embodiment, the electromagnetic field detection unit 5 and the displacement detection unit 6 are formed on the same substrate 4. However, the electromagnetic field detection unit 5 and the displacement detection unit 6 may be formed on separate substrates, for example, the displacement detection unit 6 may be arranged outside the housing 2.

It can be applied to a device having a different appearance shape, a device to which other functions are added, or the like as long as it is a shift device having a detecting unit equipped with an electromagnetic field detection unit in which a transmission circuit which generates an electromagnetic field by supplying a high-frequency signal and a reception circuit which is formed in the transmission circuit and can receive the electromagnetic field generated by the transmission circuit to generate a voltage are formed on a substrate and which is formed along a displacement direction of a shaft member, a shielding portion which is close to the electromagnetic field detection unit at a position corresponding to the displacement of the shaft member and shields the electromagnetic field generated by the transmission circuit of the electromagnetic field detection unit, and a displacement detection unit which can detect the displacement of the shaft member based on a voltage change in the reception circuit caused by the shielding of the electromagnetic field by the shielding portion.

## Claims

1. A shift device (1) for transmitting a shift operation of a shift pedal of a vehicle to a transmission to perform a gear-shifting operation, comprising:
a shaft member (L) which is configured to be displaced according to the shift operation of the shift pedal of the vehicle;
a housing (2) which is configured to accommodate the shaft member (L) in a displaceable manner and move integrally with the shaft member (L) in a state where the shaft member (L) reaches a displacement end to perform the gear-shifting operation of the vehicle;
a detecting unit which is configured to detect displacement of the shaft member (L) with respect to the housing (2); and
an accommodation case (3),
**characterized in that**
the detecting unit includes:
an electromagnetic field detection unit (5), in which a transmission circuit (5a) which is configured to generate an electromagnetic field by supplying a high-frequency signal, and a reception circuit (5b, 5c) which is formed in the transmission circuit (5a) and which is configured to receive the electromagnetic field generated by the transmission circuit (5a) to generate a voltage, are formed on a substrate (4), and which is formed along a displacement direction of the shaft member (L);
a shielding portion (Le) which is close to the electromagnetic field detection unit (5) at a position corresponding to the displacement of the shaft member (L) and which is configured to shield the electromagnetic field generated by the transmission circuit (5a) of the electromagnetic field detection unit (5); and
a displacement detection unit (6) which is configured to detect the displacement of the shaft member (L) based on a voltage change in the reception circuit (5b, 5c) caused by shielding of the electromagnetic field by the shielding portion (Le), wherein the accommodation case (3) accommodates the electromagnetic field detection unit (5), and
the shielding portion (Le) is configured to slide on a slide receiving surface (3c) formed on the accommodation case (3) corresponding to the displacement of the shaft member (L).

2. The shift device (1) according to claim 1, wherein
the shaft member (L) is made of a metal member capable of shielding the electromagnetic field generated by the transmission circuit (5a) and the shielding portion (Le) is made of a part of the shaft member (L).

3. The shift device (1) according to claim 2, wherein
the shielding portion (Le) includes a protruding end surface formed so as to protrude from the shaft member (L) toward the electromagnetic field detection unit (5).

4. The shift device (1) according to any one of claims 1 to 3, wherein
in the shaft member (L), a sliding surface (Lf) is formed on a side opposite to a side, where the shielding portion (Le) is formed, and a slide receiving surface (2d) configured to slide the sliding surface (Lf) is formed on the housing (2).

5. The shift device (1) according to any one of claims 1 to 4, wherein
the electromagnetic field detection unit (5) and the displacement detection unit (6) are formed on a same substrate (4).

## Patentansprüche

1. Schaltvorrichtung (1) zum Übertragen einer Schaltbetätigung eines Schaltpedals eines Fahrzeugs zu einem Getriebe zum Durchführen eines Gangschaltvorgangs, umfassend:
ein Wellenelement (L), das so ausgeführt ist, dass es entsprechend der Schaltbetätigung des Schaltpedals des Fahrzeugs verschoben wird;
ein Gehäuse (2), das so ausgeführt ist, dass es das Wellenelement (L) verschiebbar aufnimmt und sich in einem Zustand integral mit dem Wellenelement (L) bewegt, in dem das Wellenelement (L) ein Ende der Verschiebung erreicht, um den Gangschaltvorgang des Fahrzeugs durchzuführen;
eine Erfassungs-Einheit, die so ausgeführt ist, dass sie Verschiebung des Wellenelementes (L) in Bezug auf das Gehäuse (2) erfasst; und
ein Aufnahme-Gehäuse (3),
**dadurch gekennzeichnet, dass**
die Erfassungs-Einheit enthält:
eine Einheit (5) für Erfassung eines elektromagnetischen Feldes, in der eine Sende-Schaltung (5a), die so ausgeführt ist, dass sie ein elektromagnetisches Feld durch Zuführen eines Hochfrequenzsignals erzeugt, sowie eine Empfangs-Schaltung (5b, 5c), die in der Sende-Schaltung (5a) ausgebildet und so ausgeführt ist, dass sie das von der Sende-Schaltung (5a) erzeugte elektromagnetische Feld empfängt, um eine Spannung zu erzeugen, auf einem Substrat (4) ausgebildet sind, und die entlang einer Verschiebungsrichtung des Wellenelementes (L) ausgebildet ist;
einen Abschirmabschnitt (Le), der sich in der Nähe der Einheit (5) für Erfassung eines elektromagnetischen Feldes an einer Position befindet, die der Verschiebung des Wellenelementes (L) entspricht, und der so ausgeführt ist, dass er das von der Sende-Schaltung (5a) der Einheit (5) für Erfassung eines elektromagnetischen Feldes erzeugte elektromagnetische Feld abschirmt; sowie
eine Einheit (6) für Erfassung von Verschiebung, die so ausgeführt ist, dass sie die Verschiebung des Wellenelementes (L) auf Basis einer Spannungsänderung in der Empfangs-Schaltung (5b, 5c) erfasst, die durch Abschirmen des elektromagnetischen Feldes durch den Abschirmabschnitt (Le) verursacht wird, wobei
das Aufnahme-Gehäuse (3) die Einheit (5) für Erfassung eines elektromagnetischen Feldes aufnimmt,
und
der Abschirmabschnitt (Le) so ausgeführt ist, dass er auf einer Gleit-Aufnahmefläche (3c), die an dem Aufnahmegehäuse (3) ausgebildet ist, entsprechend der Verschiebung des Wellenelementes (L) gleitet.

2. Schaltvorrichtung (1) nach Anspruch 1, wobei
das Wellenelement (L) aus einem Metallelement besteht, das in der Lage ist, das von der Sende-Schaltung (5a) erzeugte elektromagnetische Feld abzuschirmen, und der Abschirmabschnitt (Le) aus einem Teil des Wellenelementes (L) besteht.

3. Schaltvorrichtung (1) nach Anspruch 2, wobei
der Abschirmabschnitt (Le) eine vorstehende Endfläche einschließt, die so ausgebildet ist, dass sie von dem Wellenelement (L) in Richtung der Einheit (5) für Erfassung eines elektromagnetischen Feldes vorsteht.

4. Schaltvorrichtung (1) nach einem der Ansprüche 1 bis 3, wobei
in dem Wellenelement (L) eine Gleitfläche (Lf) an einer Seite ausgebildet ist, die einer Seite gegenüberliegt, an der der Abschirmabschnitt (Le) ausgebildet ist, und eine Gleit-Aufnahmefläche (2d), die so ausgeführt ist, dass sie die Gleitfläche (Lf) gleiten lässt, an dem Gehäuse (2) ausgebildet ist.

5. Schaltvorrichtung (1) nach einem der Ansprüche 1 bis 4, wobei
die Einheit (5) für Erfassung eines elektromagnetischen Feldes und die Einheit (6) für Erfassung von Verschiebung auf demselben Substrat (4) ausgebildet sind.

## Revendications

1. Dispositif de changement de vitesse (1) pour transmettre une opération de changement de vitesse d'une pédale de changement de vitesse d'un véhicule à une transmission pour effectuer une opération de changement de vitesse, comprenant:
un élément d'arbre (L) qui est configuré pour être déplacé selon l'opération de changement de vitesse de la pédale de changement de vitesse du véhicule;
un logement (2) qui est configuré pour recevoir l'élément d'arbre (L) d'une manière déplaçable et se déplacer intégralement avec l'élément d'arbre (L) dans un état où l'élément d'arbre (L) atteint une extrémité de déplacement pour effectuer l'opération de changement de vitesse du véhicule;
une unité de détection qui est configurée pour détecter le déplacement de l'élément d'arbre (L) par rapport au logement (2); et
un boîtier de réception (3),
**caractérisé en ce que**
l'unité de détection comprend:
une unité de détection de champ électromagnétique (5), dans laquelle un circuit de transmission (5a) qui est configuré pour générer un champ électromagnétique en fournissant un signal haute fréquence, et un circuit de réception (5b, 5c) qui est formé dans le circuit de transmission (5a) et qui est configuré pour recevoir le champ électromagnétique généré par le circuit de transmission (5a) pour générer une tension, sont formés sur un substrat (4), et qui est formé le long d'une direction de déplacement de l'élément d'arbre (L);
une partie blindage (Le) qui est proche de l'unité de détection de champ électromagnétique (5) à une position correspondant au déplacement de l'élément d'arbre (L) et qui est configurée pour blinder le champ électromagnétique généré par le circuit de transmission (5a) de l'unité de détection de champ électromagnétique (5); et
une unité de détection de déplacement (6) qui est configurée pour détecter le déplacement de l'élément d'arbre (L) sur la base d'un changement de tension dans le circuit de réception (5b, 5c) provoqué par le blindage du champ électromagnétique par la partie blindage (Le), dans laquelle le boîtier de réception (3) loge l'unité de détection de champ électromagnétique (5), et
la partie blindage (Le) est configurée pour coulisser sur une surface de réception de coulisse (3c) formée sur le boîtier de réception (3) correspondant au déplacement de l'élément d'arbre (L).

2. Dispositif de déplacement (1) selon la revendication 1, dans lequel l'élément d'arbre (L) est constitué d'un élément métallique capable de protéger le champ électromagnétique généré par le circuit de transmission (5a) et la partie de protection (Le) est constituée d'une partie de l'élément d'arbre (L).

3. Dispositif de changement (1) selon la revendication 2, dans lequel la partie blindage (Le) comprend une surface d'extrémité en saillie formée de manière à faire saillie de l'élément d'arbre (L) vers l'unité de détection de champ électromagnétique (5).

4. Dispositif de déplacement (1) selon l'une quelconque des revendications 1 à 3, dans lequel
dans l'élément d'arbre (L), une surface de glissement (Lf) est formée sur un côté opposé à un côté, où la partie blindage (Le) est formée, et une surface de réception de glissement (2d) configurée pour faire glisser la surface de glissement (Lf) est formée sur le logement (2).

5. Dispositif de déplacement (1) selon l'une quelconque des revendications 1 à 4, dans lequel
l'unité de détection de champ électromagnétique (5) et l'unité de détection de déplacement (6) sont formées sur un même substrat (4).
